# EUROPEAN PATENT APPLICATION

(11) **EP 3 846 203 A1**
(43) Date of publication of application: **07.07.2021**
(21) Application number: 20210573.0
(22) Date of filing: 30.11.2020
(51) Int. Cl.: H01L 23/367, H01L 23/473

(54) **POWER MODULE**

(30) Priority: 06.01.2020 KR 20200001622
(71) Applicant: LG Electronics Inc., Yeongdeungpo-gu Seoul 07336 (KR)
(72) Inventor: CHO, Seongmoo, 08592 Seoul (KR); KIM, Kwangsoo, 08592 Seoul (KR); CHOI, Siho, 08592 Seoul (KR); LEE, Gun, 08592 Seoul (KR)
(74) Representative: Vossius & Partner Patentanwälte Rechtsanwälte mbB

(57) **Abstract**

The present disclosure provides a power module including a substrate, an electronic element provided on the substrate, and a cooling fin portion provided on one surface of the substrate to form a flow path portion through which cooling water flows. The cooling fin portion is formed asymmetrically so that amounts of heat transferred by the cooling water acting on the electronic element are different.

As a result, regions in which heat is directly transferred between cooling water and the electronic element can be increased and a pressure drop of cooling water flowing through the flow path portion can be prevented by the cooling fin portion forming an asymmetrical structure of the flow path portion. In addition, a heat dissipation performance of the power module by the cooling water can be further improved.

## Description

### BACKGROUND

### 1. Technical Field

The present disclosure relates to a power module to which a direct cooling method using cooling water is applied.

### 2. Description of the Related Art

An eco-friendly vehicle powered by hydrogen or electricity includes a power converter. And one of key components of the power converter is a power module. Such a power module has been developed with technology for improving its performance along with a development of eco-friendly vehicles.

When the power module is operated, it exhibits a high amount of heat generation centering on an electric element. And a temperature rise of the power module directly affects a performance and durability of the power module. Accordingly, in main technical development fields of the power module, further improving a cooling performance of the power module is included.

A cooling method of the power module is divided into single-sided cooling and double-sided cooling according to a surface to be cooled, and can be divided into a direct cooling method and an indirect cooling method according to a type of cooling.

The direct cooling method of the power module is generally implemented in a manner that heat is transferred by conduction and convection between cooling water flowing through a flow path formed on one surface or both surfaces of the power module and one surface of the power module.

Meanwhile, a development on a design optimized for further improving heat dissipation performance of the power module to which the direct cooling method in which heat is transferred between cooling water and the power module is applied may be considered.

### SUMMARY

One aspect of the present disclosure is to provide a cooling water flow path structure in an asymmetric shape that can further improve heat dissipation performance of a power module according to an arrangement of electronic elements provided in the power module.

Another aspect of the present disclosure is to provide a cooling water flow path structure in an asymmetric shape so that amounts of heat transfer are exhibited differently in different regions of the substrate.

In order to achieve the aspects of the present disclosure, there is provided a power module, including a substrate, an electronic element provided on the substrate, and a cooling fin portion provided on one surface of the substrate to form a flow path portion through which cooling water flows, wherein the flow path portion is formed asymmetrically on one surface of the substrate so that amounts of heat transferred by the cooling water acting on the electronic element are different depending on each arrangement of the electronic element.

The cooling fin portion may be configured such that sizes of areas for heat dissipation regions on one surface of the substrate facing the flow path portion are different from each other according to each arrangement of the electronic element.

The cooling fin portion may be configured such that volumes of the flow path portion are different from each other according to each arrangement of the electronic element.

The flow path portion may include a first flow path formed on a first region of the substrate where at least a part thereof overlaps the electronic element, and a second flow path formed on a second region of the substrate rather than on the first region and formed such that an amount of heat transferred by the cooling water acting on the electronic element is smaller than that of the first flow path.

The cooling fin portion may include a first cooling fin disposed on the first region and forming the first flow path, and a second cooling fin spaced apart from the first cooling fin on the second region and forming the second flow path.

The first cooling fin and the second cooling fin may be respectively extended along a second direction intersecting a first direction in which cooling water flows.

The power module may further include a plate that is disposed on an opposite side of the substrate with the cooling fin portion therebetween to form the flow path portion, wherein at least one of the first cooling fin and the second cooling fin may include a first portion contacting one surface of the substrate, a second portion contacting one surface of the plate facing the one surface of the substrate, and a third portion connecting the first portion and the second portion, wherein the first to third portions may be formed continuously along the second direction.

The first portion and the second portion may be arranged continuously along the second direction, and the first to third portions may be formed in a shape in which one body is bent.

The first cooling fin and the second cooling fin may, respectively, form a first thickness and a second thickness along the first direction, and wherein the first thickness may be made to be thicker than the second thickness.

The first cooling fin and the second cooling fin may be arranged alternately along the first direction with being spaced apart from each other.

The first cooling fin and the second cooling fin may be arranged in which at least a part of the first flow path and a part of the second flow path overlap each other in the first direction.

The power module may further include a plate that is disposed on an opposite side of the substrate with the cooling fin portion therebetween to form the flow path portion, wherein at least one of the first cooling fin and the second cooling fin may include a first pillar and a second pillar which are formed such that both ends thereof are respectively in contact with one surface of the substrate and one surface of the plate facing the one surface of the substrate, and spaced apart from each other along the second direction.

At least one of the first cooling fin and the second cooling fin may further include a connecting member disposed between the first pillar and the second pillar to connect the first pillar and the second pillar.

One surface of the connecting member may contact one surface of the plate.

The substrate may be provided in plurality and consist of an upper substrate and a lower substrate, and the cooling fin portion may include a first cooling fin portion provided on the upper substrate and a second cooling fin portion provided on the lower substrate.

The cooling fin portion may include a curved surface portion provided on at least a part forming the flow path portion and bent in a curved shape.

### BRIEF DESCRIPTION OF THE DRAWINGS

FIG. 1 is a perspective view illustrating one embodiment of a power module according to the present disclosure.
FIG. 2 is a perspective view of an inside of the power module illustrated in FIG. 1.
FIG. 3 is a conceptual view of an arrangement of electronic elements and a cooling fin portion of the power module illustrated in FIG. 2 viewed from a plane.
FIG. 4 is a conceptual view of a cross section of the power module illustrated in FIG. 1.
FIG. 5 is a conceptual view of the cooling fin portion illustrated in FIG. 2 viewed from a first direction illustrated in FIG. 2.
FIG. 6 is an enlarged conceptual view of a part of the cooling fin portion illustrated in FIG. 2.
FIG. 7 is a conceptual view of another embodiment of the cooling fin portion illustrated in FIG. 2 viewed from the first direction illustrated in FIG. 2.
FIG. 8 is a conceptual view of still another embodiment of the cooling fin portion illustrated in FIG. 2 viewed from the first direction illustrated in FIG. 2.

### DETAILED DESCRIPTION OF THE PREFERRED EMBODIMENT

Hereinafter, a power module 100 according to the present disclosure will be described in detail with reference to the accompanying drawings.

For the sake of brief description with reference to the drawings, the same or equivalent components will be provided with the same reference numbers, and description thereof will not be repeated.

A singular representation may include a plural representation unless it represents a definitely different meaning from the context.

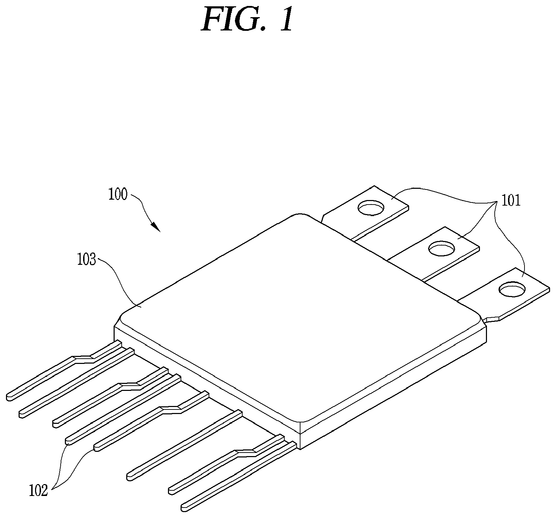

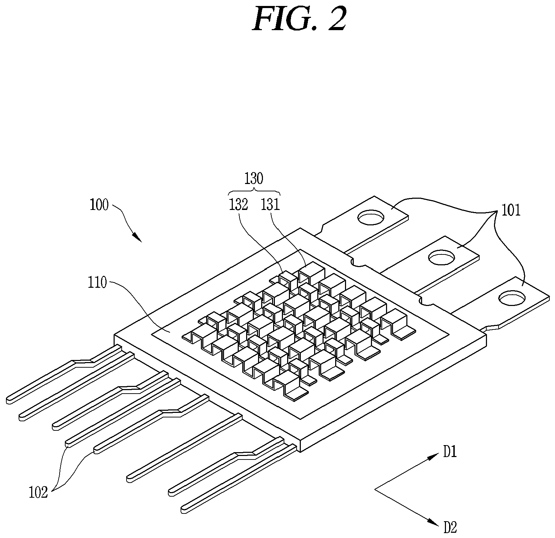

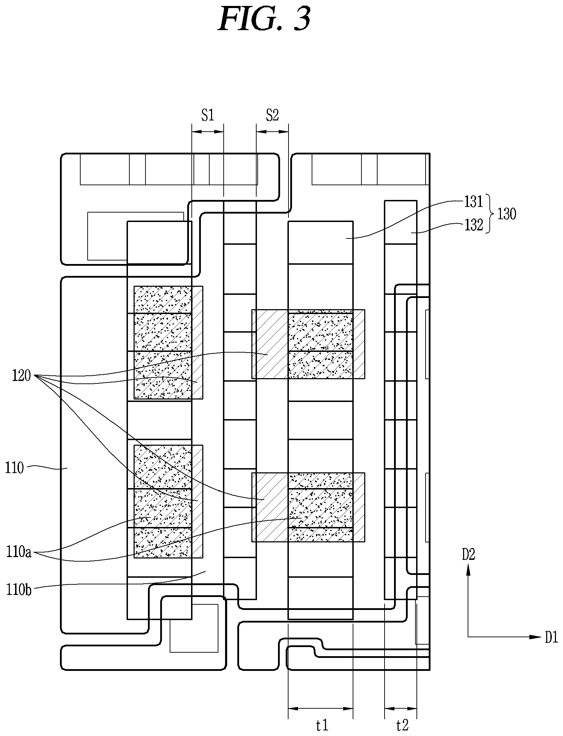

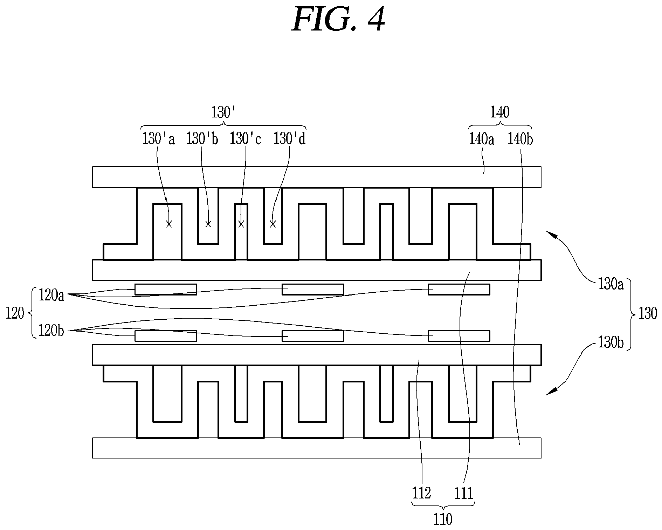

FIG. 1 is a perspective view illustrating one embodiment of the power module 100 according to the present disclosure. FIG. 2 is a perspective view of an inside of the power module 100 illustrated in FIG. 1. FIG. 3 is a conceptual view of an arrangement of electronic elements 120 and a cooling fin portion 130 of the power module 100 illustrated in FIG. 2 viewed from a plane. FIG. 4 is a conceptual view of a cross section of the power module 100 illustrated in FIG. 1.

Referring to FIGS. 1 to 4, the power module 100 is one of core components that constitutes a power converter for an eco-friendly vehicle that uses electricity as a main power source. In addition, the power module 100 of the present disclosure is applicable to all module components to which a direct cooling method using cooling water is applicable.

The power module 100 generally exhibits high amount of heat generated during operation. Accordingly, the power module 100 may be configured to have various heat dissipation mechanisms. To this end, the power module 100 of the present disclosure includes a substrate 110, an electronic element 120, and a cooling fin portion 130. The substrate 110, the electronic element 120, and the cooling fin portion 130 may be disposed in an accommodating space provided in an inner side of a housing 103 that defines an appearance of the power module 100. In addition, on one side and another side of the power module 100, a first terminal portion 101 and a second terminal portion 102 for electrical connection with other components associated with the power module 100 may be provided, respectively.

The substrate 110 is a plate on which an electric circuit is provided, and components constituting the electric circuit may be provided on the substrate 110. The components constituting the electric circuit may include the electronic element 120 to be described later, an integrated circuit, or a resistor. The substrate 110 may be comprised of an upper substrate 111 and a lower substrate 112 located below the upper substrate 111 as illustrated in FIG. 4.

The substrate 110 may be made of an insulating material. The insulating material may include a ceramic material. In addition, the substrate 110 may include a heat sink made of a metal material such as copper (Cu) to discharge heat generated from the electronic element 120 and the like.

The electronic element 120 is configured to implement functions of the power module 100, and may be provided singular or plural. When a plurality of electronic elements 120 is provided, each of the electronic elements 120 may be configured identically or differently. Meanwhile, FIG. 3 illustrates four electronic elements 120 respectively disposed in different regions on the substrate 110. FIG. 4 illustrates electronic elements 120 including three upper elements 120a provided on the upper substrate 111 and three lower elements 120b provided on the lower substrate 112.

The electronic element 120 may be a power semiconductor element. The power semiconductor element may be any one of, for example, an insulated gate transistor (IGBT), a bipolar, and a power metal oxide silicon field effect transistor (MOSFET).

The cooling fin portion 130 is provided on one surface of the substrate 110 to form a flow path portion 130' through which cooling water flows. The cooling fin portion 130 may include a first cooling fin portion 130a provided on one surface of the upper substrate 111 and a second cooling fin portion 130b provided on one surface of the lower substrate 112. A double-sided heat dissipation structure of the power module 100 may be implemented by the configuration of the first and second cooling fin portions 130a and 130b.

The cooling fin portion 130 is configured to form the flow path portion 130' asymmetrically rather than symmetrically so that an amount of heat transferred by the cooling water acting on the electronic element 120 is to be different according to an arrangement of the electronic element 120 provided on the substrate 110. Here, the symmetric form means that a point, a line, a plane, or a group of them lies at a same distance from a point, a line, and a plane interposed therebetween. On the other hand, the asymmetric form means that the symmetry is not provided. In addition, the cooling fin portion 130 may be defined in various shapes such as a pin type, a ribbon type, a pipe type, and a tunnel type. The cooling fin portion 130 may have a hollow portion including an empty space therein. In addition, the cooling fin portion 130 may be integrally formed together with the substrate 110 to form one body. Alternatively, the cooling fin portion 130 may be bonded on one surface of the substrate 110.

The cooling fin portion 130 of the present disclosure has an asymmetric structure so that the flow path portion 130' has the asymmetry based on any one point, one line, or one plane on at least a part of a region on one surface of the substrate 110.

More specifically, the asymmetric structure of the cooling fin portion 130 may have a plurality of regions having different shapes, for example, as illustrated in FIG. 4. The plurality of regions may include a first region 130'a, a second region 130'b, a third region 130'c, and a fourth region 130'd.

In addition, the cooling fin portion 130 is provided in plurality as illustrated in FIG. 2, and may include a first cooling fin 131 and a second cooling fin 132. The first cooling fin 131 and the second cooling fin 132 may have different structures so that the flow path portion 130' has different shapes.

Here, the structure of the cooling fin portion 130 having the asymmetry can be implemented by alternately arranging the first cooling fin 131 and the second cooling fin 132 that have different structures and form the flow path portion 130' on one surface of the substrate 110.

In addition, the asymmetric structure of the cooling fin portion 130 can also be implemented by arranging the flow path portion 130' formed by the first cooling fin 131 and the second cooling fin 132 on different positions on one surface of the substrate 110. For example, the first cooling fin 131 and second cooling fin 132 may be disposed on one surface of the substrate 110 in such a manner that centers of the flow path portion 130' do not overlap each other when viewed from a first direction D1 in which the cooling water flows.

Meanwhile, more detailed structures of the first cooling fin 131 and the second cooling fin 132 implementing the asymmetric structure will be described later with reference to other drawings of the present disclosure.

In addition, although the flow path portion 130' is defined in a substantially rectangular shape when viewed from the first direction D1 in which the cooling water flows in this drawing, the flow path portion 130' may also be defined in a polygonal or curved shape. Further, the asymmetric structure or the asymmetry of the flow path portion 130' described in the present disclosure can be implemented according to other structural differences due to volumes of the flow path portion 130' even if the shape of the flow path portion 130' viewed from the first direction D1 is identical.

Meanwhile, as illustrated in FIG. 4, the power module 100 may further include a plate 140 disposed on an opposite side of the substrate 110 with the substrate 110 therebetween to form the flow path portion 130'. As illustrated in FIG. 4, the flow path portion 130' may have a space in which one side and another side of the cooling fin portion 130 are surrounded by the substrate 110 and the plate 140, respectively.

The plate 140 may contain, for example, aluminum (Al) material. The plate 140 may include a first plate 140a provided on the first cooling fin portion 130a side and a second plate 140b provided on the second cooling fin portion 130b side.

According to the power module 100 of the present disclosure described above, a cooling water flow path structure of an asymmetric shape in which the substrate 110 has different amount of heat transfer in different regions may be provided. Accordingly, it can be designed that an entire region of the substrate 110 has more various heat dissipation features compared to the cooling water flow path structure of a symmetric shape in the related art.

Furthermore, in terms of increasing a heat dissipation effect of the power module 100, the heat dissipation effect of the power module 100 of the present disclosure can be maximized by forming a flow path portion 130' exhibiting relatively high amount of heat transfer in a region on the substrate 110 where an electronic element generating high amount of heat transfer is disposed on, and by forming a flow path portion 130' exhibiting relatively low amount of heat transfer in a region on the substrate 110 without an electronic element.

Here, a structure of the flow path portion 130' in which the amount of heat transferred by the cooling water is relatively high, such as a first flow path 131', causes a pressure drop (pressure loss) of the cooling water, and such a pressure drop of the cooling water decreases flow rate of the cooling water and consequently causes a problem of reducing the amount of heat transferred by the cooling water. In general, the power module 100 to which direct cooling method using cooling water is applied has an acceptable standard for pressure drop of the cooling water. For this reason, there is a limitation in applying the structure of the flow path portion 130' exhibiting high amount of heat transfer to increase the amount of heat transferred by the cooling water.

In applying the structure of the flow path portion 130', the power module 100 of the present disclosure is configured to limit the pressure drop due to the cooling water within an acceptable range by forming the first flow path 131' together with the second flow path 132' having an amount of heat transfer lower than that of the first flow path 131' on one surface of the substrate 110.

Specifically, in the cooling fin portion 130 of the present disclosure, pressure drop of the cooling water flowing through the flow path portion 130' can be prevented and heat dissipation performance of the power module 100 by the cooling water can be greatly improved by disposing a flow path portion 130' exhibiting a relatively high heat transfer amount, such as the first flow path 131', to overlap the electronic element 120, and disposing a flow path portion 130' exhibiting a relatively low heat transfer amount, such as the second flow path 132' in a region without the electronic element. Here, a more detailed description of the first flow path 131' and the second flow path 132' will be provided later.

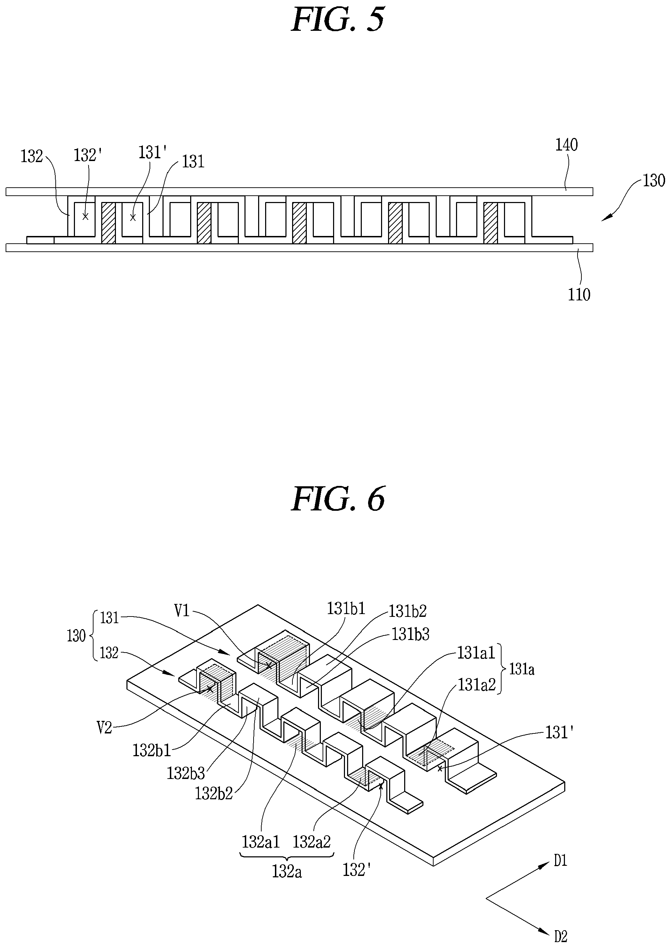

Hereinafter, a more detailed structure of the cooling fin portion 130 will be described with reference to FIGS. 1 to 4 and with reference to FIGS. 5 and 6.

FIG. 5 is a conceptual view of the cooling fin portion 130 illustrated in FIG. 2 viewed from the first direction D1 illustrated in FIG. 2, and FIG. 6 is an enlarged conceptual view of a part of the cooling fin portion 130 illustrated in FIG. 2.

Referring to FIGS. 1 to 6, the flow path portion 130' may include the first flow path 131' and the second flow path 132'.

The first flow path 130' is formed on a first region 110a of the substrate 110 where at least a portion of the substrate 110 overlaps the electronic element 120.

The second flow path 132' is formed on a second region 110b which is a remaining portion of the substrate 110 rather than on the first region 110a. In addition, the second flow path 132' is formed such that the amount of heat transferred by the cooling water acting on the electronic element 120 is smaller than that of the first flow path 131'. Further, since the second region 110b corresponds to the remaining portion of the substrate 110 on which the first region 110a is not provided, the second region 110b may have a region partially overlapping the electronic element 120 as illustrated in FIG. 3. Meanwhile, the first flow path 131' and the second flow path 132' may be formed to communicate with each other so that the cooling water flows continuously.

Here, the portion where the substrate 110 overlaps the electronic element 120 may be defined based on a viewpoint viewed from a direction perpendicular to one surface of the substrate 110, as illustrated in FIG. 3.

In addition, the cooling fin portion 130 may include the first cooling fin 131 and the second cooling fin 132.

The first cooling fin 131 may be disposed on the first region 110a to form the first flow path 131'.

The second cooling fin 132 may be spaced apart from the first cooling fin 131 at a predetermined interval on the second region 110b to form the second flow path 132'. Distances s1 and s2 between the first cooling fin 131 and the second cooling fin 132 may be equal or different. The distances s1 and s2 between the first cooling fin 131 and the second cooling fin 132 may be set according to an arrangement structure of the electronic element 120 on the substrate 110.

In addition, the first cooling fin 131 and the second cooling fin 132 may be formed to extend along a second direction D2 intersecting the first direction D1 in which the cooling water flows, as illustrated in FIG. 2. In addition, any one of the first cooling fin 131 and the second cooling fin 132 may extend along a direction different from the first direction D1 and the second direction D2. For example, the first cooling fin 131 may extend along the second direction D2, and the second cooling fin 132 may extend along a direction different from the first and second directions D1 and D2.

Meanwhile, at least one of the first cooling fin 131 and the second cooling fin 132 may include first portions 131b1 and 132b1, second portions 131b2 and 132b2, and third portions 131b3 and 131b3.

The first portions 131b1 and 132b1 may be formed to contact one surface of the substrate 110.

The second portions 131b2 and 132b2 may be formed to contact one surface of the plate 140 facing the one surface of the substrate 110.

The third portions 131b3 and 131b3 may be formed to connect the first portions 131b1 and 132b1 and the second portions 131b2 and 132b2.

Here, the first to third portions 131b1, 132b1, 131b2, 132b2, 131b3, and 131b3 may be continuously formed along the second direction D2 intersecting the first direction D1 in which the cooling water flows.

In addition, the first portion and the second portion are continuously arranged along the second direction, and the first to third portions 131b1, 132b1, 131b2, 132b2, 131b3, and 131b3 may be formed in a shape in which one body is bent. That is, at least one of the first cooling fin 131 and the second cooling fin 132 may be continuously formed without a disconnected portion.

Meanwhile, as illustrated in FIG. 3, the first cooling fin 131 and the second cooling fin 132 may be formed to have a first thickness t1 and a second thickness t2, respectively, along the first direction D1. And the first thickness t1 of the first cooling fin 131 may be greater than the second thickness t2 of the second cooling fin 132. According to the structure of the first cooling fin 131 and the second cooling fin 132, the structure of the flow path portion 130' may be formed differently in the first cooling fin 131 and second cooling fin 132. Accordingly, the flow path portion 130' may be implemented such that the amount of heat transfer by the cooling water on the substrate 110 is different depending on arrangements of the first cooling fin 131 and second cooling fin 132.

Meanwhile, the first cooling fin 131 and the second cooling fin 132 may be alternately spaced apart from each other along the first direction D1 in which the cooling water flows. According to the structure of the first cooling fin 131 and second cooling fin 132, stable flow property of the cooling water can be implemented while having the flow path portion 130' exhibiting different amount of heat transferred by the cooling water, that is, having the flow path portion 130' with the asymmetry. For example, the flow rate of the cooling water may be relatively uniformly distributed on the substrate 110. Accordingly, deviations in load applied to the power module 100 for each region on the substrate 110 can be reduced.

In addition, referring to FIG. 5, the first cooling fin 131 and the second cooling fin 132 may be arranged such that at least some parts of the first flow path 131' and the second flow path 132' overlap each other in the first direction D1 in which the cooling water flows. Here, sizes of the regions where the first flow path 131' and the second flow path 132' overlap may be identical or partially different.

Meanwhile, the cooling fin portion 130 may be formed to have different sizes of areas for heat dissipation regions facing the flow path portion 130' in one surface of the substrate 110 according to the arrangement of the electronic element 120. Referring to FIG. 6, the heat dissipation region may be defined as a region in which the flow path portion 130' and one surface of the substrate 110 overlap each other in a direction perpendicular to one surface of the substrate 110. The area for the heat dissipation region may include, for example, a first area 131a formed by the first cooling fin 131 and a second area 132a formed by the second cooling fin 132. In addition, the first area 131a and the second area 132a may respectively have direct contact portions 131a1 and 132a1 in which one surface of the substrate 110 and the cooling water directly contact each other, and indirect contact portions 131a2 and 132a2 in which the first cooling fin 131 or the second cooling fin 132 is disposed between the cooling water and the substrate 110.

In a portion of the area for the heat dissipation region, a heat transfer due to conduction may be achieved during heat transfer by the cooling water. Here, an amount of heat transfer due to the conduction in the portion of the area for the heat dissipation region increases as the area for the heat dissipation region increases. That is, the amount of heat transfer due to the conduction can be adjusted by adjusting a size of the area for the heat dissipation region.

Meanwhile, referring to FIG. 6, volumes of the flow path portion 130' may be formed differently according to the arrangement of the electronic element 120 of the cooling fin portion 130. The volumes of the flow path portion 130' may include, for example, a first volume V1 formed by the first cooling fin 131 and a second volume V2 formed by the second cooling fin 132. A size of the first volume V1 and a size the second volume V2 may be different.

In a space of the flow path portion 130' forming the first volume V1 and the second volume V2, a heat transfer due to convection may be achieved during heat transfer by the cooling water. An amount of heat transfer due to the convection may increase as the sizes of the first and second volumes V1 and V2 increase. As described above, the power module 100 of the present disclosure can control the amount of heat transfer due to the convection by adjusting the sizes of the first volume V1 and the second volume V2.

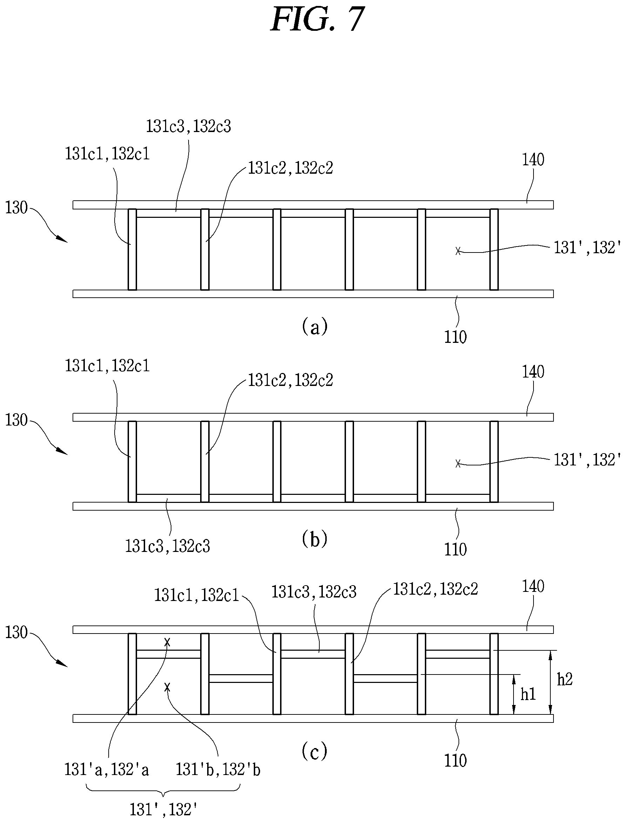

Hereinafter, another example of the cooling fin portion 130 will be described with reference to FIGS. 1 to 6, together with FIG. 7.

FIG. 7 is a conceptual view of another embodiment of the cooling fin portion 130 illustrated in FIG. 2 viewed from the first direction D1 illustrated in FIG. 2.

Referring to FIGS. 1 to 7, at least one of the first cooling fin 131 and the second cooling fin 132 may include first pillars 131c1 and 132c1 and second pillars 131c2 and 132c2, respectively.

Both ends of the first pillars 131c1 and 132c1 and both ends of the second pillars 131c2 and 132c2 contact one surface of the substrate 110 and one surface of the plate 140 facing the one surface of the substrate 110, respectively, and may be spaced apart from each other along the second direction D2 intersecting the first direction D1 in which the cooling water flows. The first flow path 131' and the second flow path 132' may be formed by a structure of the first pillars 131c1 and 132c1 and the second pillars 131c2 and 132c2. In addition, the amount of heat transfer can be increased by increasing the size of the heat dissipation area on the substrate 110 directly contacting the cooling water. Meanwhile, distances between the first pillars 131c1 and 132c1 and the second pillars 131c2 and 132c2 may be identical or different.

In addition, at least one of the first cooling fin 131 and the second cooling fin 132 may further include connecting members 131c3 and 132c3, respectively.

The connecting members 131c3 and 132c3 are disposed between the first pillars 131c1 and 132c1 and the second pillars 131c2 and 132c2, and may connect the first pillars 131c1 and 132c1 and the second pillars 131c2 and 132c2. The connecting members 131c3 and 132c3 may be formed such that one surface thereof contacts one surface of the plate 140 to have an inverted 'U' shape, as illustrated in (a) of FIG. 7. Alternatively, one surface of the connecting members 131c3 and 132c3 may be formed to contact one surface of the substrate 110 to have a 'U' shape, as illustrated in (b) of FIG. 7.

The connecting members 131c3 and 132c3 may also be disposed at different heights from one surface of the substrate 110, as illustrated in (c) of FIG. 7. For example, one of the connecting members 131c3 and 132c3 may be disposed at a first height h1, and another one of the connecting members 131c3 and 132c3 may be disposed at a second height h2 which is different from the first height h1. According to the structure of the connecting members 131c3 and 132c3, the structure of the cooling fin portion 130 may be more diversely designed so that the amount of heat transferred by the cooling water flowing through the flow path portion 130' is exhibited differently. In addition, by the structure of the connecting members 131c3 and 132c3 disposed at different heights, the first flow path 131' and the second flow path 132' may have upper flow paths 131'a and 132'a and lower flow paths 131'b and 132'b divided by the connecting members 131c3 and 132c3.

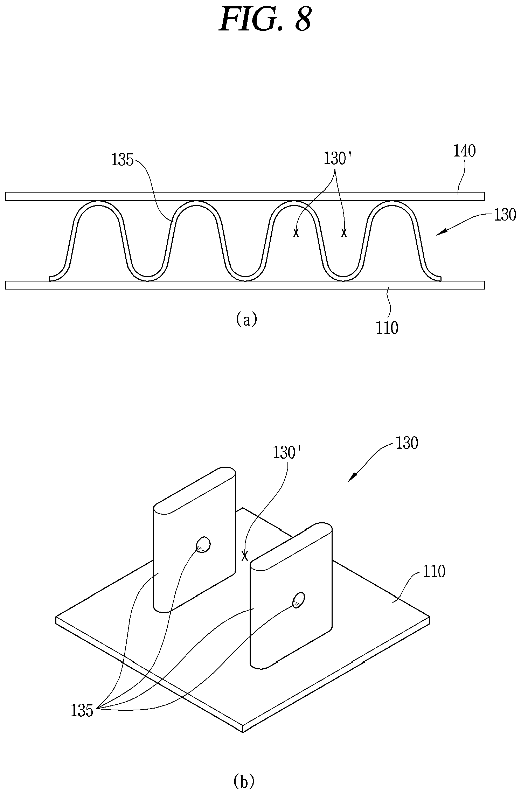

Hereinafter, another example of the cooling fin portion 130 will be described with reference to FIGS. 1 to 7, together with FIG. 8.

FIG. 8 is a conceptual view of still another embodiment of the cooling fin portion 130 illustrated in FIG. 2 viewed from the first direction D1 illustrated in FIG. 2.

Referring to FIGS. 1 to 8, the cooling fin portion 130 may be provided in at least a part forming the flow path portion 130' and may include a curved surface portion 135 bent in a curved shape, as illustrated in (a) of FIG. 8. Accordingly, resistance applied to the cooling water flowing through the flow path portion 130' can be reduced.

In addition, the curved surface portion 135 may be provided on an inlet side of the flow path portion 130' into which the cooling water is introduced, as illustrated in (b) of FIG. 8. Accordingly, resistance of flow path applied to the cooling water flowing into the flow path portion 130' can be reduced.

In addition, the curved surface portion 135 may be protruded or recessed from one surface of the cooling fin portion 130, as illustrated in (b) of FIG. 8. According to the structure of the curved surface portion 135, an amount of pressure applied to the cooling water generated in the flow path portion 130' can be partially controlled. Accordingly, the flow path portion 130' can be implemented in more various forms.

According to the present disclosure with the above-described configuration, regions in which heat is more directly transferred between cooling water and the electronic element which is a main heating source of the power module can be increased by the structure of the cooling fin portion formed on one surface of the substrate to implement an asymmetrical flow path portion through which cooling water flows, according to the structure of the electronic element provided on the substrate. As a result, a pressure drop of cooling water flowing through the flow path portion can be prevented and heat dissipation performance of the power module by the cooling water can be greatly improved by forming the flow path portion asymmetrically so that the amount of the heat transferred by the cooling water varies depending on the arrangement structure of the electronic element together with the cooling fin portion.

In addition, as the cooling fin portion has different sizes of areas for the heat dissipation regions facing the flow path portion on one surface of the substrate or the volumes of the flow path portion are different, the flow path portion can be formed asymmetrically so that the amounts of heat transferred by cooling water are different. Accordingly, design constraints on the structure of the cooling fin portion can be alleviated to provide a flow path portion having more diverse shapes.

## Claims

1. A power module (100) comprising:
a substrate (110);
an electronic element (120) provided on the substrate (110); and
a cooling fin portion (130) provided on one surface of the substrate (110) to form a flow path portion (130') through which cooling water flows,
wherein the flow path portion (130') is formed asymmetrically on one surface of the substrate (110) so that amounts of heat transferred by the cooling water acting on the electronic element (120) are different depending on each arrangement of the electronic element (120).

2. The power module (100) of claim 1, wherein the cooling fin portion (130) is configured such that sizes of areas for heat dissipation regions on one surface of the substrate (110) facing the flow path portion (130') are different from each other according to each arrangement of the electronic element (120).

3. The power module (100) of claim 1 or 2, wherein the cooling fin portion (130) is configured such that volumes of the flow path portion (130') are different from each other according to each arrangement of the electronic element (120).

4. The power module (100) of any one of the preceding claims, wherein the flow path portion (130') comprises:
a first flow path (131') formed on a first region (110a) of the substrate (110) where at least a part thereof overlaps the electronic element (120); and
a second flow path (132') formed on a second region (110b) of the substrate (110) rather than on the first region (110a) and formed such that an amount of heat transferred by the cooling water acting on the electronic element (120) is smaller than that of the first flow path (131').

5. The power module (100) of claim 4, wherein the cooling fin portion (130) comprises:
a first cooling fin (131) disposed on the first region (110a) and forming the first flow path (131'); and
a second cooling fin (132) spaced apart from the first cooling fin (131) on the second region (110b) and forming the second flow path (132').

6. The power module (100) of claim 5, wherein the first cooling fin (131) and the second cooling fin (132) are, respectively, extended along a second direction intersecting a first direction in which cooling water flows.

7. The power module (100) of claim 6, further comprising:
a plate (140) that is disposed on an opposite side of the substrate (110) with the cooling fin portion (130) therebetween to form the flow path portion (130'),
wherein at least one of the first cooling fin (131) and the second cooling fin (132) comprises:
a first portion (131b1, 132b1) contacting one surface of the substrate (110);
a second portion (131b2, 132b2) contacting one surface of the plate (140) facing the one surface of the substrate (110); and
a third portion (131b3, 132b3) connecting the first portion (131b1, 132b1) and the second portion (131b2, 132b2),
wherein the first to third portions (131b1, 132b1, 131b2, 132b2, 131b3, 132b3) are formed continuously along the second direction.

8. The power module (100) of claim 7, wherein the first portion (131b1, 132b1) and the second portion (131b2, 132b2) are arranged continuously along the second direction, and the first to third portions (131b1, 132b1, 131b2, 132b2, 131b3, 132b3) are formed in a shape in which one body is bent.

9. The power module (100) of any one of claims 6 to 8, wherein the first cooling fin (131) and the second cooling fin (132) respectively form a first thickness (t1) and a second thickness (t2) along the first direction, and
wherein the first thickness (t1) is made to be thicker than the second thickness (t2).

10. The power module (100) of any one of claims 6 to 9, wherein the first cooling fin (131) and the second cooling fin (132) are arranged alternately along the first direction with being spaced apart from each other.

11. The power module (100) of any one of claims 6 to 10, wherein the first cooling fin (131) and the second cooling fin (132) are arranged in which at least a part of the first flow path (131') and a part of the second flow path (132') overlap each other in the first direction.

12. The power module (100) of claim 6, further comprising:
a plate (140) that is disposed on an opposite side of the substrate (110) with the cooling fin portion (130) therebetween to form the flow path portion (130'),
wherein at least one of the first cooling fin (131) and the second cooling fin (132) comprises:
a first pillar (131c1, 132c1) and a second pillar (131c2, 132c2) which are formed such that both ends thereof are respectively in contact with one surface of the substrate (110) and one surface of the plate (140) facing the one surface of the substrate (110), and spaced apart from each other along the second direction.

13. The power module (100) of claim 12, wherein at least one of the first cooling fin (131) and the second cooling fin (132) further comprises:
a connecting member (131c3, 132c3) disposed between the first pillar (131c1, 132c1) and the second pillar (131c2, 132c2) to connect the first pillar (131c1, 132c1) and the second pillar (131c2, 132c2).

14. The power module (100) of claim 13, wherein one surface of the connecting member (131c3, 132c3) contacts one surface of the plate (140).

15. The power module (100) of any one of claims 1 to 14, wherein the cooling fin portion (130) comprises a curved surface portion (135) provided on at least a part forming the flow path portion (130') and bent in a curved shape.
